# EUROPÄISCHE PATENTANMELDUNG

(11) **EP 1 320 166 A1**
(43) Veröffentlichungstag der Anmeldung: **18.06.2003**
(21) Anmeldenummer: 01811213.6
(22) Anmeldetag: 12.12.2001
(51) Int. Cl.: H02H 9/02

(54) **Vorrichtung der Supraleitungstechnik**

(71) Anmelder: ABB RESEARCH LTD., 8050 Zürich (CH)
(72) Erfinder: Donzel, Lise, 5430 Wettingen (CH); Lakner, Martin, 5413 Birmenstorf (CH); Chen, Makan, 5102 Rupperswil (CH); Paul, Willi, 8006 Zürich (CH)
(74) Vertreter: ABB Patent Attorneys

(57) **Zusammenfassung**

Die vorliegende Erfindung betrifft eine Supraleiteranordnung, insbesondere einen supraleitenden Strombegrenzer, und seine dazugehörige Kühlanordnung. Um zu vermeiden, dass bei einer durch einen Fehlerstrom verursachten Erwärmung des Supraleiters flüssiger Stickstoff 21 verdampft und die Supraleiteranordnung 10 mechanisch belastet wird, ist zwischen dem Supraleiter und dem Flüssigstickstoffreservoir ein Kältemoderator 22 vorgesehen. Dieser weist einen begrenzenden Moderatorquerschnitt 222 auf, welcher eine Kühlung der Anordnung im Dauerbetrieb ermöglicht, aber verhindert, dass die im Fehlerfall entstehende Wärmemenge an das Flüssigstickstoffreservoir weitergeleitet wird. Bevorzugt weist der Kältemoderator 22 ein poröses oder saugfähiges Material zur Aufnahme oder Tränkung mit Kühlflüssigkeit auf.

## Beschreibung

### TECHNISCHES GEBIET

Die vorliegende Erfindung bezieht sich auf das Gebiet der Anwendung der Hochtemperatursupraleitung im Bereich der Stromversorgung. Sie betrifft eine Vorrichtung der Supraleitungstechnik gemäss dem Oberbegriff des Patentanspruchs 1.

### STAND DER TECHNIK

Hochtemperatursupraleiter finden beispielsweise Verwendung in supraleitenden Kurzschluss-Strombegrenzem für elektrische Verteil- oder Übertragungsnetze. Bei einem solchen Strombegrenzer wird ausgenutzt, dass ein Supraleiter bei einer entsprechend tiefen Nenn- oder Betriebstemperatur seine Supraleitfähigkeit nur solange beibehält, als die Stromdichte eines ihn durchfliessenden Stromes unterhalb eines gewissen, als kritische Stromdichte bezeichneten Grenzwertes bleibt. Tritt im entsprechenden Stromversorgungsnetzwerk ein Kurzschluss auf, wächst der Strom im Strombegrenzer zu einem den kritischen Wert übertreffenden Fehlerstrom an.

Aber auch andere supraleitende Bauteile wie Übertragungskabel oder Transformatoren weisen inhärent eine kritische Stromstärke (I_{C}) auf. Im Nennbetrieb leiten diese Bauteile einen Nennstrom I_{N}, welcher kleiner ist als der kritische Strom I_{C}, verlustfrei. Auf Grund von Transienten, welche durch Schaltnetzkomponenten wie Filterkreise oder grosse Verbraucher im Versorgungsnetz erzeugt werden, kann dieser Nennstrom aber kurzzeitig zu einem Überstrom anwachsen.

Vorrichtungen auf Hochtemperatursupraleiterbasis werden normalerweise in ein flüssiges Kühlmedium, der Einfachheit halber vorzugsweise flüssigen Stickstoff (LN₂), welcher durch ein Kryostat genanntes Gefäss von der Umgebung thermisch isoliert ist, eingetaucht. Als Folge eines Fehler- oder Überstromes in einem supraleitenden Bauteil tritt der Supraleiter in den resistiven Zustand über, d.h. die am entsprechenden Abschnitt des Stromversorgungsnetzwerkes anliegende Spannung fällt zumindest kurzzeitig ganz (im Kurzschlussfall) oder teilweise am Supraleiter ab. Joulsche Wärme wird erzeugt, und der Supraleiter heizt sich unter Umständen bis weit über seine Nenntemperatur hinaus auf und erwärmt auch das ihn umgebende Kühlmedium. Besteht dieses aus flüssigem Stickstoff, so wird eine grosse Menge davon in kurzer Zeit verdampft, so dass im Kryostaten ein Überdruck entsteht und Druck- oder Schockwellen sich fast explosionsartig ausbreiten. Dadurch beginnt die Supraleitervorrichtung zu vibrieren und erleidet einen irreparablen mechanischen Schaden, beispielsweise durch Rissbildung in der Hochtemperatursupraleiterkeramik oder durch Ablösung einer Leiter- oder Trägerschicht.

In der Deutschen Offenlegungsschrift DE-A 197 46 976 ist eine Hochtemperatursupraleiteranordnung zur Verwendung in einem Strombegrenzer dargestellt. Die Anordnung umfasst eine supraleitende Schicht und eine als elektrischer Bypass ausgebildete, gelochte Stahlplatte, welche mit der supraleitenden Schicht einen Leiterverbund bildet. Die Supraleiteranordnung kann zusätzlich mechanisch stabilisiert und elektrisch isoliert werden durch faserverstärkte Verbundwerkstoffe. Die ganze Supraleiteranordnung ist in flüssigen Stickstoff eingetaucht.

In der noch unveröffentlichten Europäischen Patentanmeldung Nr. 00811222.9 ist eine Supraleiteranordnung über ein Kühlgas gekühlt, welches die Gasphase eines Kühlfluids darstellt und mit der flüssigen Phase desselben Kühlfluids in thermischem Kontakt steht. Dieses Kühlgas entsteht beispielsweise, indem die Supraleiteranordnung mit dem Kühlfluid benetzt wird.

### DARSTELLUNG DER ERFINDUNG

Aufgabe der vorliegenden Erfindung ist es, bei Vorrichtungen der Supraleitungstechnik, welche durch eine Kühlflüssigkeit auf eine Nenntemperatur T_{N} gekühlt werden, die im Fehler- oder Überstromfall auftretende mechanische Belastung der Supraleiter zu verringern und die Verfügbarkeit Letzterer zu erhöhen. Diese Aufgabe wird durch eine Vorrichtung der Supraleitungstechnik mit den Merkmalen des Patentanspruchs 1 gelöst.

Kern der Erfindung ist es, bei einer abrupten Erwärmung einer Supraleiteranordnung eine Verdampfung der Kühlflüssigkeit und das damit verbundene Auftreten von Schockwellen zu verhindern. Dies wird erreicht, indem besagte Kühlflüssigkeit, welche ein Kältereservoir der Nenntemperatur T_{N} bildet, nicht in unmittelbaren Kontakt mit der Supraleiteranordnung gebracht, sondern über einen festen Kältemoderator thermisch daran angekoppelt wird. Der Kältemoderator steht grossflächig über seine Moderatorhauptfläche mit einer Oberfläche eines Leiterverbundes und über eine Moderatornebenfläche mit dem Kältereservoir in thermischem Kontakt. Wärmeleittechnisch gesehen zwischen diesen Moderatorflächen weist der Kältemoderator einen thermischen Moderatorquerschnitt auf, dessen Ausdehnung kleiner ist als die Moderatorhauptfläche und welcher das Wärmeleitvermögen des Kältemoderators bestimmt. Dieses Wärmeleitvermögen ist so bemessen, dass im Nenn- oder Dauerbetrieb die geringen Restverluste des Supraleiters abgeführt werden und Letzterer somit auf Nenntemperatur T_{N} gehalten wird. Demgegenüber soll jedoch im Quenchfall, d.h. bei Auftreten eines Fehler- oder Überstromes mit nachfolgender Erwärmung des Supraleiters um bis zu einigen 10 K, die vom Supraleiter ausgehende, beträchtliche Wärmemenge nicht oder nur verzögert zur Kühlflüssigkeit geleitet werden.

Gemäss einer ersten Ausführungsform der erfindungsgemässen Vorrichtung ist der genannte kritische Moderatorquerschnitt mit der Moderatornebenfläche identisch, d.h. die Begrenzung des Wärmeflusses zum Kältereservoir hin findet bei deren Kontakt- oder Übergangsstelle statt. Die Moderatornebenfläche ist also so gewählt, dass bei der moderatormaterialabhängigen spezifischen Wärmeleitfähigkeit das über die Moderatornebenfläche integrierte Wärmeleitvermögen für den Nennbetrieb ausreichend ist, einer darüber hinausgehenden Wärmeleitung jedoch ein thermischer Widerstand entgegengesetzt wird.

In einer bevorzugten Weiterbildung umfasst dieser Kältemoderator ein poröses Material oder ein Gewebe, dessen Poren beispielsweise infolge von Kapillarkräften mit der Kühlflüssigkeit vollgesaugt sind oder über erste Beregnungsmittel mit Kühlflüssigkeit getränkt werden. Dabei ist die im Gewebe oder in den Poren vorhandene Kühlflüssigkeitsmenge stets so gering, dass selbst bei deren instantanem Verdampfen nur ein verkraftbarer Überdruck ohne mechanisches Beschädigungspotential entsteht.

Bevorzugterweise befindet sich die Kühlflüssigkeit in demselben Volumen eines die Anordnung aufnehmenden Tankes oder Kryostaten wie der Supraleiter. Dann sind Füllstandskontrollmittel vorzusehen, welche das Kühlflüssigkeitsniveau daran hindern, zu hoch zu steigen und in direkten Kontakt mit dem Supraleiter zu treten.

In allen Fällen ist eine leistungsfähige Beregnungsmöglichkeit der Supraleiteranordnung in Form einer Kühlmitteldusche hilfreich zur Unterstützung des Abkühlvorganges nach erfolgter Erwärmung des Supraleiters infolge eines Überschreitens des Nennstromes oder beim Vorgang des erstmaligen Abkühlens von Raumtemperatur auf Betriebstemperatur anlässlich der Inbetriebnahme der Vorrichtung. Aus demselben Grund ist gegebenenfalls auch der Träger, auf welchem die Leiterbahnen aufgebracht sind, mit dem Kältereservoir thermisch verbunden.

Das Problem der explosionsartigen Verdampfung von Kühlflüssigkeit ist insbesondere bei Strombegrenzern akut, da diese darauf ausgelegt sind, im Kurzschlussfall innert kürzester Zeit einen grossen Widerstand aufzubauen und viel Energie zu dissipieren. Resistive Strombegrenzer umfassend plattenförmige Module mit je einem elektrisch isolierenden Träger und beidseitig aufgebrachten Leiterbahnen sind umso stärker gefährdet, je grösser die Ausdehnung der Module ist. Dies deshalb, weil bei gleichbleibender Moduldicke die Schwingungsamplituden umso grösser sind, je grösser die Ausdehnung der Module, d.h. die Fläche der Platten, ist. Da erfindungsgemäss weniger mechanische Belastungen auftreten, ist es nun auch möglich, Module einzusetzen, welche eine Ausdehnung von mehr als 0.05 m² aufweisen.

Weitere vorteilhafte Ausführungsformen gehen aus den abhängigen Patentansprüchen hervor.

### KURZE BESCHREIBUNG DER FIGUREN

Nachfolgend wird die Erfindung anhand von Ausführungsbeispielen im Zusammenhang mit den Zeichnungen näher erläutert. Es zeigen nicht-massstabsgetreu und im Schnitt
Fig.1 eine Vorrichtung mit einer Kühlanordnung nach dem Stand der Technik,
Fig.2 eine Vorrichtung mit einer Kühlanordnung nach der Erfindung,
Fig.3 eine Vorrichtung mit alternativen Kühlanordnungen, und
Fig.4 eine Vorrichtung mit einem zusätzlichen Beregnungsmittel.

Die in den Zeichnungen verwendeten Bezugszeichen sind in der Bezugszeichenliste zusammengefasst. Grundsätzlich sind gleiche Teile mit denselben Bezugszeichen versehen.

### WEGE ZUR AUSFÜHRUNG DER ERFINDUNG

In den Figuren ist dargestellt jeweils ein resistiver supraleitender Strombegrenzer 1, mit zwei oder vier plattenförmigen Modulen 10,10', welche elektrisch in Serie geschaltet sind und von einem Strom I durchflossen werden. Jedes Modul 10,10' umfasst ein Substrat oder sonstigen zweidimensionalen Träger 11, auf dessen zumindest einer Trägerhauptfläche 110 Leiterbahnen 12 beispielsweise in Form eines fortlaufenden oder spiralförmigen Mäanders aufgebracht sind. Der Stromfluss erfolgt dabei senkrecht zu den in den Figuren erkenntlichen Leiterbahnquerschnitten. Die Leiterbahnen 12 bestehen aus einem Leiterverbund aus einem Supraleiter und einem Normalleiter, welcher mit dem Supraleiter flächenhaft verbunden ist und einen elektrischen Bypass für diesen darstellt. Weiter sind elektrisch isolierende und/oder mechanisch stützende Deckschichten 13, beispielsweise aus Epoxidharz beziehungsweise Faserverbundwerkstoff, als Abdeckung der Leiterbahnen 12 denkbar. Die Module 10,10' sind nebeneinander angeordnet und bilden Zwischenräume 14. Die Module 10,10' beziehungsweise deren Träger 11 sind auf dem Boden oder den Wänden eines den Strombegrenzer 1 umgebenden Kryostaten 20 abgestützt. Damit keine Luftfeuchtigkeit einfriert ist der Kryostat 20 geschlossen und mit einem nicht dargestellten Überdruckventil versehen.

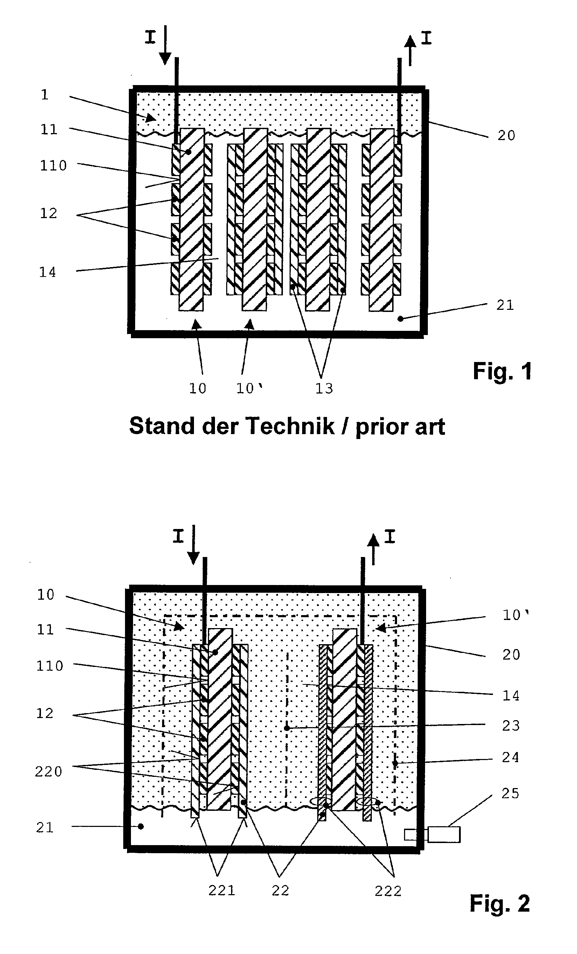

In Fig.1 ist eine Kühlanordnung 2 nach dem Stand der Technik dargestellt. Die Module 10,10' des Strombegrenzers 1 beziehungsweise die Gesamtheit aller Leiterbahnen 12 sind dabei in eine Kühlflüssigkeit 21 eingetaucht. Der thermische Kontakt erfolgt über die einer Trägerhauptfläche 110 abgewandte Seite der Leiterbahnen 12, und gegebenenfalls über die Deckschicht 13. Eine Wellenlinie stellt die Phasengrenzfläche zwischen der Kühlflüssigkeit und seiner gasförmigen Phase, d.h. das Füllstandsniveau der Kühlflüssigkeit, dar.

In Fig.2 ist eine Kühlanordnung 2 mit einem erfindungsgemässen Kältemoderator 22 und einer Kühlflüssigkeit 21, welche ein Kältereservoir auf einer Nenntemperatur T_{N} (T_{N} = 77 K für flüsssigen Stickstoff LN₂) bildet, dargestellt. Die der Trägerhauptfläche 110 abgewandte Seite der Leiterbahnen 12 steht mit einer Moderatorhauptfläche 220 eines Kältemoderators 22 in thermischem Kontakt, d.h. die Leiterbahnen 12 sind, unmittelbar oder eventuell über die genannte Deckschicht 13, an den Kältemoderator 22 thermisch angekoppelt. Der Kältemoderator 22 ist in das Kältereservoir der Temperatur T_{N} eingetaucht, welches als Kühlflüssigkeit 21 den Boden des Kryostaten 20 bedeckt. Somit stehen über den Kältemoderator 22 auch die Leiterbahnen 12 mit dem Kältereservoir 21 in thermischem Kontakt und weisen im Normalfall eine Betriebstemperatur auf, welche gleich der Nenntemperatur T_{N} ist oder leicht darüber liegt. Der genannte thermische Kontakt der Leiterbahnen 12 mit dem Kältereservoir 21 erfolgt aber erfindungsgemäss nie direkt, sondern nur über den Kältemoderator 22 oder allenfalls den Träger 11. Der Kältemoderator 22 verfügt über einen reduzierten Querschnitt 222, welcher im Wesentlichen den Gesamt-Wärmeleitwiderstand bestimmt.

Gleichzeitig ist gemäss Fig.2 auch der untere Teil der Träger 11 des Strombegrenzers 1 in das Kältereservoir 21 eingetaucht. Träger 11 und Moderator 22 weisen beide ein optimiertes Wärmeleitvermögen auf und bilden zusätzlich Wärmezwischenspeicher oder -puffer, welche eine vom Leiterverbund ausgehende kurzzeitige Erwärmung nur langsam weiterleiten. Der Kältemoderator 22 ist entweder (Module 10, links) aus einem porösen, saugfähigen Material gefertigt, so dass durch Kapillarkräfte die Kühlflüssigkeit 21 aus dem Kältereservoir aufsteigt. Geeignet dafür sind auch mit der Kühlflüssigkeit getränkte textile Materialien oder Zelluloseprodukte wie Pressboard oder Papier oder poröse Sinterschichten. Alternativ (Module 10', rechts) ist der Kältemoderator 22 ein Metall, welches mit oder ohne elektrisch isolierende Zwischenschicht auf den Bypass des Leiterverbundes der Leiterbahnen 12 aufgebracht ist.

Um die Ausbildung von Temperaturgradienten zwischen dem Boden des Kryostaten 20 und dem oberen Teil der Module zu verhindern, sind thermische Ausgleichselemente 23 eingebaut. Diese bestehen aus einem gut wärmeleitenden Material, wobei unter Umständen auch Metalle wie Kupfer oder Aluminium denkbar sind, oder aus einem porösen, saugfähigen Material analog zum vorhergehend Genannten, so dass durch Kapillarkräfte das flüssige Kühlmedium 21 in einen Bereich des Zwischenraumes 14 aufsteigt. Ebenso sind thermische Schilde 24 geeignet, um Temperaturgradienten im Gas zwischen der Supraleiteranordnung 1 und dem Kryostaten 20 zu verringern und statt dessen im Schild 24 zu konzentrieren. Weiter sind Mittel 25 zur Verhinderung eines Anstiegs des Kühlflüssigkeitsniveaus exemplarisch gezeigt. Diese umfassen einen Füllstandssensor, welcher einen kritischen Level entdeckt und eine Pumpe oder ein Heizelement startet, welche dafür sorgen, dass überschüssige Kühlflüssigkeit weggepumpt oder verdampft wird.

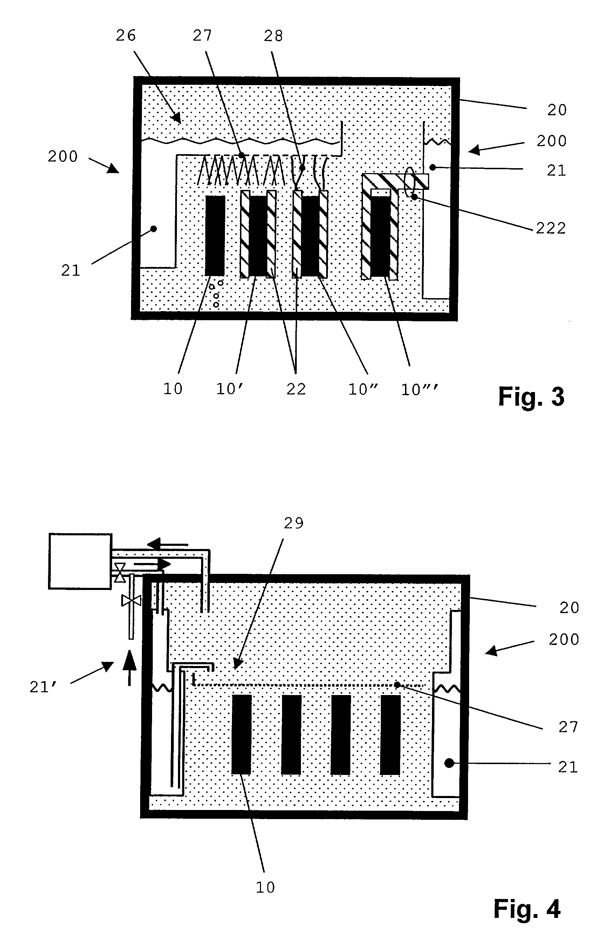

In Fig. 3 und 4 sind die vier Module 10, 10', 10", 10'" der Einfachheit halber nur noch als schwarze Balken dargestellt. In Fig.3 liegt das Kältereservoir mit der Kühlflüssigkeit 21 in einem Teilvolumen 200 entlang der Aussenwand des Kryostaten 20 und weist ein Füllstandsniveau auf, welches oberhalb der Module 10 liegt. Die Kühlanordnung umfasst erste Beregnungsmittel 26, welche es erlauben, die Module zu benetzen oder zu beregnen. Die Benetzung erfolgt über eine Anordnung mit Düsen oder indem von einem Lochblech 27 mit kleinen Öffnungen Tropfen der Kühlflüssigkeit 21 direkt auf die Supraleiteranordnung 1 fallen (erstes Modul 10). Idealerweise benetzen die Beregnungsmittel 26 die Module über deren ganze Breite beziehungsweise Tiefe gleichmässig, so dass sich ein kontinuierlicher Kühlflüssigkeitsfilm über die gesamte, der Trägerhauptfläche 110 abgewandte Seite der Leiterbahnen 12 ausbildet. Ist dabei die erwähnte Deckschicht 13 mit kanalartigen Strukturen oder zumindest einer gewissen Oberflächenrauhigkeit versehen, so wird die auftreffende Kühlflüssigkeit auch wirklich gleichmässig verteilt.

Vorteilhafterweise sind die Module von einem Kältemoderator 22 aus dem bereits erwähnten porösen oder saugfähigen Material umgeben, d.h. beispielsweise umwickelt oder bedeckt (Fig.3, zweites Modul 10'). Dabei ist wiederum die Menge an zugeführter Kühlflüssigkeit ausreichend, um die Restverluste zu vernichten, aber dennoch so gering, dass im Quenchfall nur ein kleines unschädliches Gasvolumen entsteht. Zudem ist eine homogenere Verteilung über die ganze Moduloberfläche gewährleistet. Im dritten Modul 10" wird der poröse Kältemoderator 22 nicht beregnet, sondern ist über einen Flüssigkeitsleiter 28, beispielsweise Textilfäden, mit dem Kältereservoir verbunden. Die Kühlflüssigkeit wird in diesem Fall durch die Flüssigkeitsleiter 28 zum saugfähigen Kältemoderator 22 geleitet. In der Darstellung ganz rechts (viertes Modul 10'") ist der Kältemoderator 22 selbst direkt mit dem Kältereservoir verbunden.

In Fig.4 ist eine für alle Ausführungsformen wichtige Ergänzung zur raschen Abkühlung der Supraleiteranordnung bei Inbetriebnahme oder nach einem Quench mit kurzzeitiger Erwärmung der Leiterverbunde über die Betriebstemperatur dargestellt. Entlang der Aussenwand des Kryostaten 20 ist wiederum ein äusseres Teilvolumen 200 als Behälter für die Kühlflüssigkeit 21 vorgesehen, welches in diesem Fall aber vollständig vom restlichen Hauptvolumen abgetrennt ist. Vom Teilvolumen 200 gehen zweite Beregnungsmittel 29 aus, welche eine Anordnung mit Düsen oder ein Lochblech 27 mit Öffnungen umfassen. Im Gegensatz zur ersten Beregnungsvorrichtung 26 sind in diesem zweiten Fall die Öffnungen des Lochblechs grösser und/oder zahlreicher, da ein grösserer Kühlmittelfluss erreicht werden muss. Die Kühlleistung wird über den hydrostatischen Druck im äusseren Teilvolumen 200 des Kryostaten 20 geregelt. Mittels Zufuhr von unter Druck stehendem Gas 21' kann die Kühlleistung schnell erhöht werden, was insbesondere zur Abkühlung der Supraleiteranordnung nach einem Kurzschluss geeignet ist. Das verdampfte Kühlgas wird beispielsweise in einem Kryokühler wieder kondensiert.

Das Problem der durch mechanische Belastung hervorgerufenen Rissbildung in Hochtemperatursupraleiterkeramiken ist nicht auf einen bestimmten Hochtemperatursupraleiter-Typ und/oder ein bestimmtes Verfahren zu seiner Herstellung beschränkt. In Strombegrenzeranwendungen eingesetzt wird beispielsweise schmelzprozessiertes Bi₂Sr₂CaCu₂O₈ als polykristallines Bulkmaterial mit Schichtdicken vorzugsweise zwischen 50 und 1000 µm.

Damit lassen sich Module präparieren mir einer Ausdehnung in der Ebene senkrecht zur Schnittebene der Figuren von bis zu einigen 0.1 m². Module dieser Grösse sind allerdings wie gesagt bei Vibrationen mehr gefährdet, und dies trotz des Einsatzes von Faserverbundwerkstoffen oder von elektrisch isolierten metallischen Substraten als Träger oder als zusätzliche Verstärkungsschichten. Aus diesem Grund ist die Verwendung grosser Module erst dank der erfindungsgemässen Vibrationsvermeidung möglich. Die Module weisen im Übrigen untereinander einen seitlichen Abstand von 2 - 20 mm auf.

Die vorgängig am Beispiel eines resistiven supraleitenden Strombegrenzers erläuterte Erfindung ist keineswegs auf planare Modul- oder Trägergeometrien gebunden. Der erfindungsgemässe Verzicht auf ein vollständiges Eintauchen der Supraleiteranordnung in eine Kühlflüssigkeit ist auch bei anderen Bauteilen der Supraleitungstechnik sinnvoll. Beispielsweise kann der Träger ein Spulenkörper eines Transformators sein, auf welchen die Leiterbahnen als Wicklungen aufgebracht sind. Auch hier resultieren weniger mechanische Beschädigungen, und dementsprechend ein verringerter Austauschbedarf und eine höhere Verfügbarkeit der Vorrichtung.

### BEZUGSZEICHENLISTE

- 1: Strombegrenzer
- 10,10': Modul
- 11: Träger
- 110: Trägerhauptfläche
- 12: Leiterbahn
- 13: Deckschicht
- 14: Zwischenraum
- 2: Kühlanordnung
- 20: Kryostat
- 200: Teilvolumen
- 21: Kühlflüssigkeit
- 22: Kältemoderator
- 220: Moderatorhauptfläche
- 221: Moderatornebenfläche
- 222: Moderatorquerschnitt
- 23: thermisches Ausgleichselement
- 24: thermischer Schild
- 25: Füllstandskontrollmittel
- 26: Erste Beregnungsmittel
- 27: Lochblech
- 28: Flüssigkeitsleiter
- 29: Zweite Beregnungsmittel

## Patentansprüche

1. Vorrichtung der Supraleitungstechnik, umfassend
eine Hochtemperatursupraleiteranordnung mit einem Träger (11), welcher eine Trägerhauptfläche (110) aufweist, und Leiterbahnen (12), welche auf der Trägerhauptfläche (110) angeordnet sind und Hochtemperatursupraleitermaterial aufweisen, sowie
eine Kühlanordnung mit einer Kühlflüssigkeit (21) als Kältereservoir zur Kühlung der Hochtemperatursupraleiteranordnung auf eine Nenntemperatur T_{N}, und einem Kältemoderator (22), welcher über eine Moderatorhauptfläche (220) mit einer der Trägerhauptfläche (110) abgewandten Oberfläche der Leiterbahnen (12) sowie über eine Moderatomebenfläche (221) mit dem Kältereservoir in thermischem Kontakt steht,
**dadurch gekennzeichnet, dass**
der Kältemoderator (22) einen thermisch zwischen der Moderatorhauptfläche (220) und der Moderatornebenfläche (221) liegenden Moderatorquerschnitt (222) aufweist, welcher kleiner ist als die Moderatorhauptfläche (220).

2. Vorrichtung nach Anspruch 1, **dadurch gekennzeichnet, dass** die Moderatornebenfläche (221) der Moderatorquerschnitt (222) ist.

3. Vorrichtung nach einem der Ansprüche 1 oder 2, **dadurch gekennzeichnet, dass** der Kältemoderator (22) in das Kältereservoir eingetaucht ist und ein poröses Material mit Poren zur Aufnahme von Kühlflüssigkeit (21) umfasst.

4. Vorrichtung nach einem der Ansprüche 1 oder 2, **dadurch gekennzeichnet, dass** der Kältemoderator (22) ein poröses Material umfasst, und dass das Kältereservoir erste Beregnungsmittel (26) zur Befeuchtung des Kältemoderators (22) mit Kühlflüssigkeit (21) aufweist.

5. Vorrichtung nach einem der Ansprüche 1 oder 2, **dadurch gekennzeichnet, dass** der Kältemoderator (22) in das Kältereservoir eingetaucht ist und ein metallisches Material umfasst.

6. Vorrichtung nach einem der Ansprüche 3 bis 5, wobei sich die Kühlflüssigkeit (21) und die Hochtemperatursupraleiteranordnung in demselben Volumen eines Kryostaten (20) befinden, **dadurch gekennzeichnet, dass** Füllstandskontrollmittel (25) vorhanden sind, welche verhindern, dass ein Füllstand der Kühlflüssigkeit (21) höher steigt als ein tiefster Punkt der Leiterbahnen (12) der Hochtemperatursupraleiteranordnung.

7. Vorrichtung nach einem der Ansprüche 3 bis 5, **dadurch gekennzeichnet, dass** zweite Beregnungsmittel (29) vorhanden sind, welche anschliessend an einen Fehler- oder Überstromfall die Hochtemperatursupraleiteranordnung mit Kühlflüssigkeit (21) beregnen.

8. Vorrichtung nach einem der Ansprüche 3 bis 5, **dadurch gekennzeichnet, dass** der Träger (11) mit der Kühlflüssigkeit (21) in thermischem Kontakt steht.

9. Vorrichtung nach einem der Ansprüche 3 bis 5, **dadurch gekennzeichnet, dass** die Hochtemperatursupraleiteranordnung ein resistiver Strombegrenzer mit plattenförmigen Modulen (10,10') ist.

10. Vorrichtung nach Anspruch 9, **dadurch gekennzeichnet, dass** die Module (10,10') eine Ausdehnung von mindestens 0.05 m² aufweisen.
